# EUROPÄISCHE PATENTSCHRIFT

(11) **EP 3 218 230 B1**
(45) Veröffentlichungstag und Bekanntmachung des Hinweises auf die Patenterteilung: **29.12.2021**
(21) Anmeldenummer: 15804332.3
(22) Anmeldetag: 10.11.2015
(51) Int. Cl.: B60R 16/03

(54) **KRAFTFAHRZEUG-VERSORGUNGSNETZ**
MOTOR VEHICLE SUPPLY NETWORK
RÉSEAU D'ALIMENTATION DE VEHICULE AUTOMOBILE

(30) Priorität: 10.11.2014 DE 102014222878
(43) Veröffentlichungstag der Anmeldung: 20.09.2017
(73) Patentinhaber: LEONI Bordnetz-Systeme GmbH, 97318 Kitzingen (DE)
(72) Erfinder: EBERT, Matthias, 97337 Dettelbach (DE); RAU, Markus, 97318 Kitzingen (DE)
(74) Vertreter: FDST Patentanwälte
(86) Internationale Anmeldenummer: PCT/EP2015/076146
(87) Internationale Veröffentlichungsnummer: WO 2016/075106

(56) Entgegenhaltungen:
- WO-A1-97/01103
- DE-A1-102012 019 996
- US-A1- 2011 276 191
- None

## Beschreibung

Die Erfindung betrifft ein Kraftfahrzeug-Versorgungsnetz und insbesondere ein 48V-Bordnetz eines Kraftfahrzeuges.

Derzeit werden Kraftfahrzeuge mit einem Gleichstrom-Versorgungsnetz ausgestattet, welches als sogenanntes 12V-Bordnetz ausgestaltet ist und dementsprechend eine oder mehrere 12V-Spanungsquellen aufweist. Da jedoch die Anzahl der elektrischen Verbraucher in einem Kraftfahrzeug zuletzt von Fahrzeuggeneration zu Fahrzeuggeneration deutlich angestiegen ist, wird das 12V-Bordnetz als nicht zukunftsfähig angesehen.

Aktuell sehen die Planungen vieler Automobilhersteller vor, dass das 12V-Bordnetz durch ein 48V-Bordnetz, also wiederum ein Gleichstrom-Versorgungsnetz, abgelöst wird, dass also die Basisspannung, Netzspannung oder Quellspannung für das Gleichstrom-Versorgungsnetz des Kraftfahrzeuges von 12V auf 48V angehoben wird. Wie bereits in der Einleitung der auf die Anmelderin zurückgehenden Offenlegungsschrift DE 10 20 12 019 996 A1 dargelegt, resultieren aus einer solchen Anhebung der Basisspannung zusätzliche Problemstellungen, die bei der Ausgestaltung eines entsprechenden Gleichstrom-Versorgungsnetzes zu berücksichtigen sind.

Von besonderer Relevanz ist dabei das erhöhte Risiko, dass sich sogenannte Lichtbögen ausbilden, die zu einem Kabelbrand und infolgedessen auch zu einem Fahrzeugbrand führen können. Entsprechende Lichtbögen entstehen dabei z.B., wenn eine Kabelisolierung durch Reibung an einem benachbarten Bauteil oder einer benachbarten Baugruppe zumindest lokal abgetragen wird und infolgedessen dann ein Leiter des Gleichstrom-Versorgungsnetzes frei liegt und dabei dicht an einer elektrisch leitfähigen Baugruppe, wie dem Fahrzeugskelett, positioniert ist. In einem solchen Fall genügt dann bereits eine Potentialdifferenz zwischen dem frei liegenden Leiter und der leitfähigen Baugruppe von beispielsweise 15V und eine relativ geringe Leistungsübertragung über den frei liegenden Leiter von etwa 50 Watt, damit sich ein Lichtbogen zwischen dem frei liegenden Leiter und der elektrisch leitfähigen Baugruppe ausbildet.

Aus der US 2011/0276191 A1 ist eine elektrische Steuervorrichtung für ein Kraftfahrzeugversorgungsnetz bekannt. Die Steuervorrichtung weist ein Leistungsmodul mit einem Halbleiterschaltelement auf. Mittels des Steuermoduls, insbesondere mittels des Halbleiterschaltelement ist zumindest eine elektrische Last ansteuerbar. Zum Schutz des Halbleiterschaltelements vor einer Überspannung und/oder einem Überstrom, weist das Steuermodul eine Strommesseinheit sowie eine Spannungsmesseinheit auf, die in einem Überstromfall und/oder einem Überspannungsfall das Halbleiterschaltelement auf ein Massepotential elektrisch überbrücken und somit einen potentiellen Fehlerstrom ableiten.

Die WO 97/01103 A1 beschreibt eine Überwachungseinheit für eine (Kraftfahrzeug-)Batterie. Die Überwachungseinheit ist dabei derart eingerichtet und ausgebildet, dass sie die Batterie mittels eines Schalters abgeschaltet wird, wenn ein kritischer Zustand eintritt. Ein derartiger kritischer Zustand ist beispielsweise ein Sinken des Ladezustands der Batterie unter einen vorbestimmten Wert.

Ausgehend hiervon liegt der Erfindung die Aufgabe zugrunde, ein vorteilhaft ausgestaltetes Kraftfahrzeug-Versorgungsnetz anzugeben.

Diese Aufgabe wird erfindungsgemäß gelöst durch ein Kraftfahrzeug-Versorgungsnetz mit den Merkmalen des Anspruchs 1 sowie durch einen Leistungsverteiler für ein solches Versorgungsnetz mit den Merkmalen des Anspruchs 13. Bevorzugte Weiterbildungen sind in den rückbezogenen Ansprüchen enthalten.

Ein entsprechendes Kraftfahrzeug-Versorgungsnetz ist hierbei insbesondere für ein Kraftfahrzeug ausgelegt und dabei bevorzugt als Gleichstrom-Versorgungsnetz und insbesondere als 48V-Bordnetz (48-Volt-Bordnetz) ausgestaltet. Es umfasst eine Strom- oder Spannungsquelle sowie einen Leistungsverteiler, der zur Einspeisung von Leistung aus der Stromquelle über einen Zuleitungsstrompfad an die Stromquelle angebunden ist, wobei der entsprechende Zuleitungsstrompfad typischerweise zumindest abschnittsweise durch ein Leistungsübertragungskabel, oder kurz Kabel, ausgebildet ist. Weiter umfasst das Kraftfahrzeug-Versorgungsnetz zumindest eine Last, also einen elektrischen Verbraucher, die zur Versorgung mit Leistung aus dem Leistungsverteiler über einen Laststrompfad mit integriertem Halbleiterschalter an den Leistungsverteiler angebunden ist. Hierbei ist auch der Laststrompfad typischerweise zumindest abschnittsweise durch ein Kabel ausgebildet.

Der Leistungsverteiler wiederum umfasst eine Strommesseinheit, eine Spannungsmesseinheit sowie eine Überwachungseinheit, die in den Leistungsverteiler integriert und beispielsweise in einem gemeinsamen Gehäuse oder auf einer gemeinsamen Leiterplatine untergebracht sind. Dabei ist die Überwachungseinheit derart eingerichtet, dass diese einen drohenden Störfall im Kraftfahrzeug-Versorgungsnetz und insbesondere im Laststrompfad mit der zumindest einen Last anhand der Messdaten der Strommesseinheit und/oder der Messdaten der Spannungsmesseinheit erkennt und daraufhin ein Abschalten der Last mittels des Halbleiterschalters im Strompfad mit der zumindest einen Last initiiert, wobei sowohl drohende Überstrom-Störfälle als auch drohende Lichtbogen-Störfälle als drohender Störfall erkannt werden.

Das hier vorgestellte Kraftfahrzeug-Versorgungsnetz ist somit gegen verschiedene Störfälle abgesichert, so dass daraus resultierende Folgeschäden, insbesondere Kabel- oder Fahrzeugbrände, vermieden werden. Der Begriff Störfall wird dabei im Sinne dieser Anmeldung nicht für das Auftreten eines Fehlers oder Defekts, der die Funktionsfähigkeit des Gleichstrom-Verteilernetzes stört, verwendet, sondern für das Auftreten eines Ereignisses oder Systemzustandes, welches bzw. welcher durch einen Fehler oder einen Defekt im Gleichstrom-Verteilernetz hervorgerufen wird und als potentiell problematisch oder kritisch angesehen wird.

So ist zum Beispiel das Ansteigen der Stromstärke in einem Strompfad des Gleichstrom-Verteilernetzes auf einen Wert oberhalb der Nennstromstärke, also der vorgesehenen Stromstärke, zwar tendenziell als Systemfehler oder Fehler anzusehen, jedoch ist dieser Fehler nicht zwingend als kritisch zu bewerten. Erst wenn die Stromstärke über einen längeren Zeitraum hinweg über der Nennstromstärke liegt oder sehr deutlich über der Nennstromstärke liegt, ist ein Zustand erreicht, der für das Gleichstrom-Verteilernetz potentiell problematisch ist, da dann ein signifikantes Risiko für die Beschädigung einzelner Baugruppen oder Komponenten des Kraftfahrzeug-Versorgungsnetzes besteht.

Eine ähnliche Differenzierung wird weiterhin beispielsweise im Falle eines Kabelbruches vorgenommen. Ein solcher Kabelbruch stellt zwar einen Defekt dar, ist für sich genommen aber noch nicht problematisch oder kritisch. Infolge eines Kabelbruches jedoch kommt es unter Umständen zu einem Überschlag im Bereich des Kabelbruches, also zur Ausbildung eines Lichtbogens, der die Bruchstelle überbrückt, so dass der Strom wieder durch den Strompfad hindurch zur angebundenen Last fließt. Eben dieser Lichtbogen wird als potenziell problematisch oder kritisch angesehen, da dieser einen Kabel- und / oder einen Fahrzeugbrand auslösen kann.

Infolge dessen ist das Schutzsystem des Kraftfahrzeug-Versorgungsnetzes und insbesondere die Überwachungseinheit im Leistungsverteiler bevorzugt derart ausgestaltet, dass dieses bzw. diese bereits reagiert, noch bevor ein kritisches Ereignis auftritt oder ein potenziell problematischer Zustand erreicht ist. Auf diese Weise werden Folgeschäden im Kraftfahrzeug-Versorgungsnetz oder in der unmittelbaren Umgebung vermieden und das Auftreten von Lichtbögen wird unterbunden.

Weiter stehen die Begriffe drohender Überstrom-Störfall und drohender Lichtbogen-Störfall im Sinne dieser Anmeldung für verschiedene prinzipiell mögliche Bedingungen oder Situationen, auf die das Schutzsystem insbesondere durch Abschalten der zumindest einen Last reagieren soll.

Hierbei steht der Begriff drohender Überstrom-Störfall z.B. für ein Ansteigen der Stromstärke aufgrund eines sogenannten Kurzschlusses, infolgedessen die Stromstärke im betroffenen Laststrompfad auf ein Vielfaches der Nennstromstärke, also quasi der vorgesehenen Stromstärke, ansteigt. In diesem Fall ist ein möglichst schnelles Trennen des betroffenen Laststrompfades von der Energiezufuhr und somit ein Abschalten der zumindest einen Last erwünscht und dementsprechend ist die Überwachungseinheit beispielsweise derart eingerichtet, dass ein Öffnen des Halbleiterschalters oder ein Sperren des Halbleiterschalters im Laststrompfad mit der zumindest einen Last durch die Überwachungseinheit initiiert wird, sobald durch die Strommesseinheit ein Wert größer dem 2-fachen der Nennstromstärke messtechnisch erfasst wird.

Eine relativ geringe Überschreitung der Nennstromstärke, beispielsweise bis hin zum 2-fachen Wert, wird dagegen erst dann als drohender Überstrom-Störfall bewertet und erkannt, wenn die Stromstärke im betroffenen Laststrompfad über einen vorgegebenen Zeitraum hinweg oberhalb der Nennstromstärke bleibt. Daher ist die Überwachungseinheit bevorzugt derart eingerichtet, dass diese erst dann eine Öffnung oder Sperrung des Halbleiterschalters im betroffenen Laststrompfad initiiert, wenn die Stromstärke zum Beispiel mindestens 10 s oberhalb der Nennstromstärke bleibt. Auf diese Weise wird berücksichtigt, dass in einem Gleichspannungs-Versorgungsnetz prinzipiell Schwankungen der Stromstärke auftreten können, so dass die Stromstärke in einem Strompfad des Kraftfahrzeug-Versorgungsnetzes zeitweise über dem eigentlich vorgesehenen Wert, also der Nennstromstärke, liegt. Sofern eine solche Überschreitung der Nennstromstärke jedoch nicht allzu groß ausfällt und lediglich über einen begrenzten Zeitraum hinweg anhält, ist das Risiko für einen daraus resultierenden Schaden an einer Baugruppe des Kraftfahrzeug-Versorgungsnetzes und insbesondere an der zumindest einen Last als gering einzustufen und dementsprechend ist die Überwachungseinheit bevorzugt derart ausgestaltet, dass eine kurzzeitige Überschreitung der Nennstromstärke toleriert wird, solange die Stromstärke einen vorgegebenen Grenzwert, der als Hinweis auf einen Kurzschluss angesehen wird, nicht überschreitet. Das heißt also, dass mit Hilfe der Überwachungseinheit nicht nur die beiden typischen prinzipiell möglichen drohenden Überstrom-Störfälle als drohende Störfälle erkannt oder detektiert werden, sondern darüber hinaus bevorzugt auch die Art des drohenden Überstrom-Störfälls erkannt oder ermittelt wird, so dass dann z.B. differenziert auf verschiedene drohende Störfälle reagiert werden kann.

Dies gilt jedoch nicht nur für die drohenden Überstrom-Störfälle, sondern darüber hinaus auch für die drohenden Lichtbogen-Störfälle, wobei eben je nach Ausführungsvariante des Kraftfahrzeug-Versorgungsnetzes und insbesondere je nach Ausgestaltung der Überwachungseinheit entweder verschiedene drohende Störfälle lediglich detektiert werden oder aber zudem identifiziert werden. Auf diese Weise ist eine Anpassung an verschiedene Anwendungszwecke möglich und die daraus resultierende Gestaltungsfreiheit wird bevorzugt auch genutzt. Im einfachsten Fall ist dann die Überwachungseinheit derart ausgebildet, dass die verschiedensten, oder zumindest die als besonders relevant angesehenen, prinzipiell möglichen drohenden Störfälle detektiert, also erkannt werden, ohne zwischen den verschiedenen drohenden Störfällen zu differenzieren, also ohne dass erkannt wird, welcher Störfall genau droht einzutreten. In diesem Fall erfolgt dann dementsprechend unabhängig von der Art des drohenden Störfalls dieselbe Reaktion durch das System, also insbesondere das Öffnen oder Sperren des Halbleiterschalters im Strompfad mit der zumindest einen Last, wobei die Überwachungseinheit den entsprechenden Halbleiterschalter entweder über eine entsprechende Verbindung zwischen dem Halbleiterschalter und der Überwachungseinheit direkt ansteuert oder eine entsprechende Ansteuerung initiiert, indem diese z.B. eine Art Triggersignal an eine Endstufe oder Verstärkerstufe übermittelt, welche zur Ansteuerung des Halbleiterschalters eingesetzt wird.

Dabei werden auch unter dem Begriff drohender Lichtbogen-Störfall typischerweise verschiedene, teilweise in der DE 10 20 12 019 996 A1 beschriebene, potentiell mögliche drohende Störfälle zusammengefasst. Die dazugehörigen Störfälle zeichnen sich im Gegensatz zu den Überstrom-Störfällen dadurch aus, dass diese zur Entstehung oder Ausbildung von Lichtbögen, also im Prinzip zur Erzeugung eines Plasmas, führen können. Diese Lichtbögen sind dabei nicht nur unerwünscht, sondern darüber hinaus potentiell problematisch, da diese, wie eingangs dargelegt, Kabelbrände oder sogar Fahrzeugbrände auslösen können.

Hierbei ist das generelle Risiko für Lichtbögen umso höher, je höher die im Kraftfahrzeug-Versorgungsnetz zur Verfügung gestellte Spannung ist und je höher die über einen Strompfad geleitete Leistung ist. Aus diesem Grund werden bevorzugt Kraftfahrzeug-Versorgungsnetze mit einem hier vorgestellten integrierten Sicherungssystem versehen, für die eine Quellspannung oder Netzspannung größer 20 Volt vorgesehen ist, in die also zumindest eine Spannungsquelle mit einer Versorgungsspannung größer 20 Volt eingebunden ist. Weiter bevorzugt ist eine entsprechende Ausgestaltung für Kraftfahrzeug-Versorgungsnetze vorgesehen, die zumindest einen Strompfad und insbesondere einen Laststrompfad aufweisen, über welchen im Betrieb zumindest zeitweise mehr als 300 Watt und insbesondere mehr als 500 Watt, also beispielsweise etwa 1.000 Watt, zur Versorgung einer Last, also eines elektrischen Verbrauchers, geleitet werden. Bei derartigen Kraftfahrzeug-Versorgungsnetzen wird das Risiko für entsprechende Lichtbögen als nicht vernachlässigbar angesehen und dementsprechend werden diese Kraftfahrzeug-Versorgungsnetze nicht nur gegen Überströme sondern eben auch gegen Lichtbögen abgesichert.

Weiter sind bevorzugt je nach Ausführungsvariante alle oder zumindest die wesentlichen Funktionselemente, die zur Überwachung und somit zur Absicherung des Kraftfahrzeug-Versorgungsnetzes dienen, Teil des Leistungsverteilers und somit Teil einer einzigen für die Herstellung des Kraftfahrzeug-Versorgungsnetzes vorgefertigten Baueinheit. Dabei gilt es beispielsweise zu bedenken, dass heutzutage Bordnetze für Kraftfahrzeuge häufig mit Hilfe einer begrenzten Anzahl vorgefertigter Baueinheiten hergestellt werden, wobei die vorgefertigten Baueinheiten nach dem Baukasten-Prinzip auf verschiedene Weise miteinander kombiniert werden, um unterschiedliche Bordnetz-Varianten oder Bordnetz-Ausführungen zu realisieren. Durch eine Integration der für eine Absicherung vorgesehenen Funktionseinheiten in den Leistungsverteiler, also eine ohnehin vorgesehene vorgefertigte Baueinheit, kann auf einen zusätzlichen Baukasten-Baustein oder eine zusätzliche vorgefertigte Baueinheit für die Funktionselemente zur Absicherung des Kraftfahrzeug-Versorgungsnetzes verzichtet werden. Hierbei sind bevorzugt zumindest die wesentlichen Funktionseinheiten, also die Strommesseinheit, die Spannungsmesseinheit und die Überwachungseinheit, z.B. in einem gemeinsamen Gehäuse, dem Gehäuse des Leistungsverteilers, untergebracht und/oder auf einer gemeinsamen Leiterplatine realisiert.

Der Leistungsverteiler ist zudem derart ausgestaltet, dass sich der Zuleitungsstrompfad im Leistungsverteiler quasi in mehrere Laststrompfade aufspaltet, wobei über jeden dieser Lastrompfade eine Last an den Leistungsverteiler angebunden ist. Dementsprechend wird dann, ganz im Sinne des Begriffes Leistungsverteiler, die von der Stromquelle zur Verfügung gestellte elektrische Leistung im Leistungsverteiler bedarfsgerecht auf die verschiedenen angebundenen Lasten verteilt, so dass jede Last im Bedarfsfall mit ausreichend Leistung versorgt wird. Dabei ist in jeden Laststrompfad ein eigener Halbleiterschalter integriert und jeder Laststrompfad wird auf Störfälle hin überwacht. Je nach Ausgestaltungsvariante sind hierbei für jeden Laststrompfad auch eine eigene Strommesseinheit und/oder eine eigene Spannungsmesseinheit vorgesehen, mit deren Hilfe laststrompfadabhängige Strom- und Spannungsmessungen ermöglicht sind. Für die Überwachung der entsprechenden Messwerte ist hingegen bevorzugt nur eine einzige Überwachungseinheit vorgesehen und dementsprechend im Leistungsverteiler untergebracht. Das heißt also, dass bevorzugt alle vom Leistungsverteiler ausgehenden Laststrompfade durch eine einzige Überwachungseinheit überwacht werden, in dem diese Überwachungseinheit die Messdaten aller Strommesseinheiten und aller Spannungsmesseinheiten auswertet.

Hierbei ist die Überwachungseinheit zweckdienlicherweise zudem derart ausgestaltet, dass diese nicht nur einen drohenden Störfall, also einen drohenden Überstrom-Störfall oder einen drohenden Lichtbogen-Störfall, erkennt, sondern darüber hinaus auch in welchem Laststrompfad der Störfall droht, wobei dann lediglich die Last des betroffenen Laststrompfades abgeschaltet wird, in dem die Öffnung oder Sperrung des entsprechenden Halbleiterschalters durch die Überwachungseinheit initiiert wird.

Weiter ist gemäß einer vorteilhaften Ausgestaltung der Halbleiterschalter als Leistungstransistor und insbesondere als MOSFET ausgebildet, also als Metall-Oxid-Halbleiter-Feldeffekttransistor. MOSFETs lassen sich problemlos für hohe Leistungen bis hin zu mehreren 100 A und bis etwa 1.000 V auslegen (Leistungs-MOSFET) und zeichnen sich gleichzeitig durch kurze Schaltzeiten aus, wodurch derartige Transistoren prinzipielle gut geeignet sind, um Schutzschalter oder Sicherungs-Schalter zur Absicherung eines Kraftfahrzeug-Versorgungsnetzes zu realisieren.

Zudem lassen sich problemlos integrierte Schaltungen mit Hilfe entsprechender Leistungstransistoren bzw. MOSFETs aufbauen, wodurch sich zum Beispiel auch Halbleiterschalter oder Sicherungsschalter mit zusätzlichen Funktionen herstellen und im Kraftfahrzeug-Versorgungsnetz einsetzen lassen. Das heißt also, dass der Halbleiterschalter nicht zwingend durch einen einzelnen Transistor gegeben ist, sondern je nach Anwendungszweck auch komplexer aufgebaut sein kann und aufgebaut ist. So ist es unter anderem vorteilhaft, wenn in einen solchen Halbleiterschalter eine Strommesseinheit integriert ist, die die Stromstärke des über den Halbleiterschalter in einen Laststrompfad fließenden Stroms messtechnisch erfasst. Als Beispiel für einen solchen Halbleiterschalter mit zusätzlichen Funktionen sei an dieser Stelle auf die Serie oder Produktreihe PROFET^{™} der Firma Infineon verwiesen.

In bevorzugter Ausgestaltung sind auf einer gemeinsamen Leiterplatine für jede der Lasten ein jeweiliger Halbleiterschalter, eine jeweilige Strommesseinheit, eine jeweilige Spannungsmesseinheit sowie eine für alle Lasten gemeinsame Überwachungseinheit angeordnet. Sämtliche Elemente für die Überwachung sind daher kompakt auf einer gemeinsamen Leiterplatte, zumindest in einer gemeinsamen Komponente (Leistungsverteiler) integriert. Diese braucht eingangsseitig nur noch an die Stromquelle angeschlossen werden und abgangsseitig mehrere Anschlüsse (z.B. Steckanschlüsse) für die einzelnen Lastpfade aufweisen.

Weiterhin handelt es sich bei der Überwachungseinheit zweckdienlicherweise um eine universelle Überwachungseinheit, über die mehrere potentielle Störfälle überwacht werden. So ist die Überwachungseinheit vorzugsweise für jede der einzelnen Lasten zur Erfassung
- eines Überstroms,
- eines Kurzschlusses des Laststrompfades gegen Masse,
- eines parallelen Lichtbogens im Laststrompfad,
- eines seriellen Lichtbogens im Laststrompfad sowie zur Erfassung
- eines seriellen Lichtbogens in einem Massepfad zwischen der jeweiligen Last und einem Massepotenzial ausgebildet.

Die Überwachungseinheit ist bevorzugt nicht nur ausgebildet, um die verschiedensten drohenden Störfälle zu erkennen, sondern darüber hinaus auch, um was für einen drohenden Störfall es sich handelt, welcher Typ Störfall also droht einzutreten. Hierbei wird weiter bevorzugt nicht nur zwischen drohenden Überstrom-Störfällen und drohenden Lichtbogen-Störfällen unterschieden, stattdessen erfolgt in der Regel eine darüber hinausgehende Differenzierung, also unter anderem eine Differenzierung zwischen einem drohenden Überstrom-Störfall aufgrund eines Kurzschlusses und einem drohenden Überstrom-Störfall, bei dem die Stromstärke über einen längeren Zeitraum hinweg größer als die Nennstromstärke und kleiner als zum Beispiel das 2-fache der Nennstromstärke ist.

Auch ist die Überwachungseinheit bevorzugt ausgebildet, um zwischen verschiedenen drohenden Lichtbogen-Störfällen zu unterscheiden, also insbesondere zwischen einem drohenden sogenannten seriellen Lichtbogen-Störfall und einem drohenden sogenannten parallelen Lichtbogen-Störfall. Dabei wird zum Beispiel von einem drohenden seriellen Lichtbogen-Störfall gesprochen, wenn in einem Abschnitt eines Laststrompfades, der durch einen Leiterdraht oder ein Kabel ausgebildet ist, ein Kabelbruch oder Drahtbruch vorliegt oder die Leitfähigkeit aus irgendeinem anderen Grund quasi punktuell signifikant abgesetzt ist. In diesem Fall ist dann der Stromfluss im Bereich des Kabelbruches oder Drahtbruches unterbrochen oder zumindest stark reduziert, was zu einem Ladungsstau und somit zu einer relativ hohen Potentialdifferenz über eine relativ kleine Wegstrecke hinweg führt. Bei ausreichend hohem Ladungsstau bildet sich dann ein Lichtbogen aus, der die Bruchstelle oder den defekten Abschnitt überbrückt, so dass wiederum Strom quasi seriell entlang des Strompfades hin zur Last fließt. Das Auftreten des Lichtbogens ist dabei gleichzusetzen mit dem Auftreten des seriellen Lichtbogen-Störfalls.

Dagegen wird von einem parallelen Lichtbogen-Störfall gesprochen, wenn zumindest ein Teil des Stroms über einen Lichtbogen aus dem Laststrompfad heraus in einen anderen Strompfad oder einfach eine Ladungsträgersenke abfließt. Dies geschieht beispielsweise, wenn, wie Eingangs bereits dargelegt, die Isolierung eines Kabels beschädigt wird und daraufhin ein darunter liegender Leiter zumindest Abschnittsweise frei liegt und in einem relativ kurzen Abstand zu einer leitenden Struktur, wie beispielsweise einer Fahrzeugkarosserie, positioniert ist. In diesem Fall wirkt dann die Fahrzeugkarosserie oder das Fahrzeugskelett als Masse oder Masseanschluss und somit als Ladungsträgersenke für den leistungsübertragenden Laststrompfad.

Ist die Überwachungseinheit nun für eine Differenzierung oder eine differenzierte Erkennung verschiedener drohender Störfälle ausgebildet, so lassen sich diese Informationen auf unterschiedliche Weise nutzen. Wie bereits zuvor geschrieben, ist es dabei zum Beispiel vorgesehen, das Gleichstrom-Verteilernetz so auszugestalten, dass unterschiedliche drohende Störfälle auch unterschiedliche Reaktionen zur Folge haben, dass also zum Beispiel die Überwachungseinheit derart eingerichtet ist, dass diese ein Abschalten von Halbleiterschaltern je nach drohendem Störfall entweder unmittelbar nach Erkennung eines Stromwertes größer als der Nennstromwert oder aber mit vorgegebener Zeitverzögerung initiiert.

Alternativ oder ergänzend hierzu lassen sich diese Informationen an einen nicht im Leistungsverteiler angeordneten, externen Empfänger übermitteln, also zum Beispiel an ein Steuergerät im Bordnetz des Kraftfahrzeuges. Hier werden die Informationen dann beispielsweise in ein Fehlerprotokoll eingefügt und zusammen mit dem Fehlerprotokoll in einem Fehlerspeicher hinterlegt, so dass ein Wartungstechniker, der den Fehlerspeicher im Rahmen einer Wartung ausliest, auf den entsprechenden Fehler sowie Details zum Fehler hingewiesen wird. Alternativ oder ergänzend hierzu löst eine entsprechende Datenübermittlung an das Steuergerät die Generierung eines Warnsignals durch das Steuergerät aus, die den Fahrzeugführer des Kraftfahrzeuges optisch und / oder akustisch darauf hinweist, dass ein Problem vorliegt und das Aufsuchen einer Werkstatt ratsam oder notwendig ist. Ist eine solche Datenübermittlung an einen externen Empfänger vorgesehen, so weist die Überwachungseinheit hierfür bevorzugt eine Kommunikationseinheit auf, die derart eingerichtet ist, dass bei einer Erkennung eines drohenden Störfalls ein in der Kommunikationseinheit generiertes Störfallprotokoll über einen Signalausgang am Leistungsverteiler ausgegeben und, sofern angeschlossen, an einen externen Empfänger übermittelt wird.

In einigen Anwendungsfällen werden die entsprechenden Informationen zudem zusätzlich genutzt, um auf deren Basis ein Anzeigeelement, insbesondere eine Kontrollanzeige, anzusteuern. Die entsprechende Anzeige ist dabei zum Beispiel in ein Gehäuse des Leistungsverteilers integriert oder an einem Gehäuse des Leistungsverteilers angebracht und dient so zur Unterstützung eines Wartungstechnikers bei der Suche nach dem betroffenen Bauteil, was insbesondere dann von Vorteil ist, wenn mehrere derartige Leistungsverteiler in einem Kraftfahrzeug verbaut sind.

Um eine entsprechende Differenzierung zwischen verschiedenen drohenden Störfällen zu ermöglichen ist die Überwachungseinheit vorteilhafterweise derart ausgebildet, dass die mittels der Strommesseinheit und / oder mittels der Spannungsmesseinheit generierten Messdaten mit hinterlegten Strom- und / oder Spannungsprofilen verglichen werden, die für bestimmte Störfälle charakteristisch sind. Unter einem Profil ist dabei der zeitliche Verlauf eines Strom- oder Spannungswertes zu verstehen, also die zeitliche Entwicklung eines Strom- oder Spannungswertes vor und beim Auftreten eines Störfalls. Dabei lässt sich aus dem zeitlichen Verlauf nicht nur herauslesen, wann ein Störfall vorliegt, stattdessen ist es auch möglich, einen sich anbahnenden oder drohenden Störfall auszumachen, und infolge dessen zu reagieren, bevor der Störfall tatsächlich auftritt.

Im Falle des zuvor beschriebenen drohenden seriellen Lichtbogen-Störfalls wird das Auftreten eines Lichtbogens als seriellen Lichtbogen-Störfall betrachtet, den es zu unterbinden gilt. Bevor sich jedoch ein entsprechender Lichtbogen ausgebildet, verändern sich bereits die Strom- und / oder Spannungswerte beim betroffenen Laststrompfad in charakteristischer Weise und diese Änderung lässt sich durch einen Vergleich der Messwerte oder vielmehr durch einen Vergleich der zeitlichen Entwicklung der Messwerte mit einem hinterlegten Messwerteprofil erkennen.

Während die für einen Laststrompfad vorgesehene Strommesseinheit, wie zuvor beschrieben, bevorzugt in den Halbleiterschalter des entsprechenden Laststrompfades integriert ist, ist die diesem Laststrompfad zugeordnete Spannungsmesseinheit vorzugsweise Teil einer Messbrücke, dient also zur Erfassung einer Potentialdifferenz in einer Messbrücke mit einem Brückenkopf im Bereich der Last des entsprechenden Laststrompfades und mit einem Brückenkopf im Bereich des Halbleiterschalters dieses Laststrompfades. In diesem Fall sind dann alle Baugruppen oder Komponenten, die zur Realisierung einer Überwachung und Absicherung des entsprechenden Laststrompfades dienen, mit Ausnahme des Brückenkopfes im Bereich der Last Teil des Leistungsverteilers und dementsprechend im Leistungsverteiler untergebracht. Dabei ist die Messbrücke weiter bevorzugt nach Art einer sogenannten Wheatstone'schen Messbrücke ausgestaltet, basiert also auf dem Prinzip der bekannten Wheatstone'schen Messbrücke. In diesem Fall wird dann eine Spannungsmessung oder Spannungsüberwachung vorgenommen, wie sie in der DE 10 2012 019 996 A1 beschrieben wird, weswegen an dieser Stelle ausdrücklich auf die gesamte Offenbarung dieser Offenlegungsschrift Bezug genommen wird.

Wie in der Offenlegungsschrift dargelegt umfasst die Messbrücke dabei typischerweise eine Sensorleitung oder Signalleitung, die den Brückenkopf im Bereich der Last mit der Spannungsmesseinheit im Leistungsverteiler verbindet. Dabei ist die Sensorleitung zumindest in einem Abschnitt durch eine Ader oder eine Schirmung eines Leistungsübertragungs-Kabels ausgebildet, dessen übrige Adern bzw. dessen Leiter den Laststrompfad in eben diesem Abschnitt ausbilden bzw. ausbildet.

Weiter bevorzugt ist der Brückenkopf im Bereich der Last wie im zweiten Ausführungsbeispiel der DE 10 2012 019 996 A1 ausgestaltet und umfasst dementsprechend eine Bypassleitung, die den Laststrompfad, dem der Brückenkopf zugeordnet ist, vor und nach der Last anzapft und in der zwei Wiederstände in Reihe geschaltet sind. Dabei wird mittels der Sensorleitung das Potenzial zwischen den beiden in Reihe geschalteten Wiederständen abgegriffen und einem Potenzial im ergänzenden Brückenkopf gegenüber gestellt. Hierbei ist es von Vorteil, den Brückenkopf im Bereich der Last in einen Steckverbinder eines Leistungsübertragungs-Kabels zu integrieren, durch welches die Last mit dem Leistungsverteiler verbunden ist.

Die Kombination der in einem Steckverbinder integrierten Brückenkopfes mit der in den Laststrompfad integrierten Sensorleitung (separate Ader oder Schirmung) in Verbindung mit der gemeinsamen Überwachungskomponente (Leistungsverteiler), in bzw. auf der sämtliche erforderliche Elemente für die Überwachung integriert sind, hat den besonderen Vorteil, dass sämtliche Maßnahmen zur Leitungsüberwachung universell bereits vorab bereitgestellt werden können, ohne dass weitere aufwändige Konfektionierungsmaßnahmen erforderlich sind.

Ausführungsbeispiele der Erfindung werden nachfolgend anhand einer schematischen Zeichnung näher erläutert. Darin zeigen:
- FIG 1: in einem Blockschaltbild ein Gleichstrom-Verteilernetz sowie
- FIG 2: in einem Blockschaltbild ein alternatives Gleichstrom-Verteilernetz.

Einander entsprechende Teile sind in allen Figuren jeweils mit den gleichen Bezugszeichen versehen.

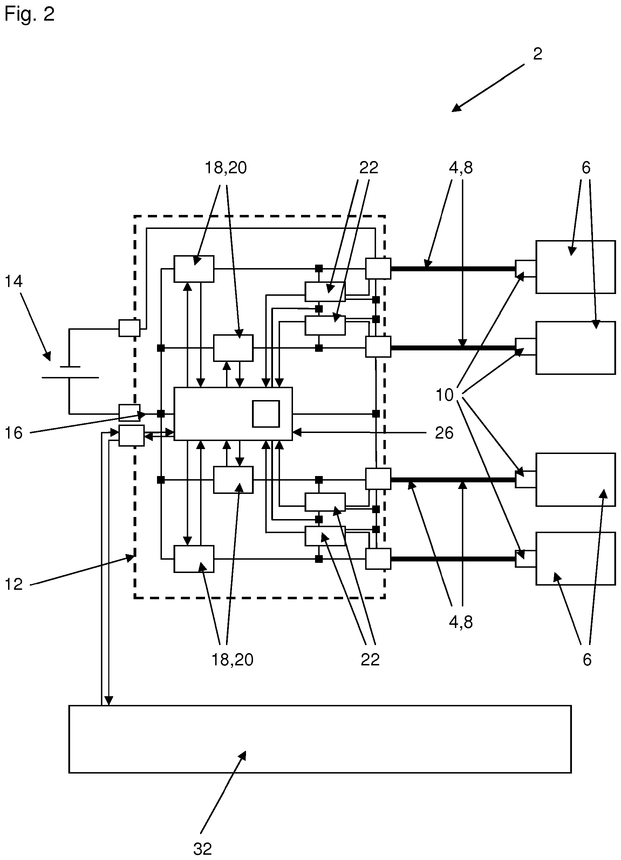

Ein nachfolgend exemplarisch beschriebenes und in Fig. 2 wiedergegebenes Kraftfahrzeug-Versorgungsnetz 2 weist mehrere Laststrompfade 4 auf, über die jeweils eine angeschlossene oder angebundene Last 6 bei Bedarf mit elektrischer Leistung versorgt wird. Dabei ist jede Last 6 mit Hilfe eines Kabels 8, welches an beiden Enden jeweils ein als Stecker 10 ausgebildetes Anschlusselement aufweist, an einen Leistungsverteiler 12 angebunden, sodass ein jeder Laststrompfad 4 zumindest Abschnittsweise durch ein Kabel 8 ausgebildet wird.

Der Leistungsverteiler 12 wiederum ist an eine Stromquelle 14 angebunden, welche elektrische Leistung im Kraftfahrzeug-Versorgungsnetz 2 zur Verfügung stellt und hierfür in den Leistungsverteiler 12 einspeist. Im Leistungsverteiler 12 spaltet sich dann ein Zuleitungsstrompfad 16, über den der Leistungsverteiler 12 an die Stromquelle 14 angebunden ist und über welchen elektrische Leistung aus der Stromquelle 14 in den Leistungsverteiler 12 gelangt, in die Laststrompfade 4 auf, über welche die Lasten 6 quasi als Endverbraucher mit elektrischer Leistung versorgt werden. Dabei liegt der Leistungsbedarf je nach Last 6 zwischen 500 W und 1500 W und dementsprechend ist das Kraftfahrzeug-Versorgungsnetz 2 ausgebildet, um elektrische Verbraucher mit einem relativ hohen Leistungsbedarf zu versorgen.

Weiter ist das Kraftfahrzeug-Versorgungsnetz 2 im hier beschriebenen Ausführungsbeispiel für ein Kraftfahrzeug ausgelegt und weist ein Sicherungssystem auf, mit dessen Hilfe das Kraftfahrzeug-Versorgungsnetz 2 sowohl gegen Überstrom-Störfälle als auch gegen Lichtbogen-Störfälle und somit daraus resultierende Folgeschäden abgesichert ist. Dabei ist das Sicherungssystem derart ausgestaltet, dass jeder Laststrompfad 4 überwacht wird und das die über einen Laststrompfad 4 versorgte Last 6 von der Versorgung abgeschnitten wird, sobald ein drohender Störfall im entsprechenden Laststrompfad 4 erkannt wird.

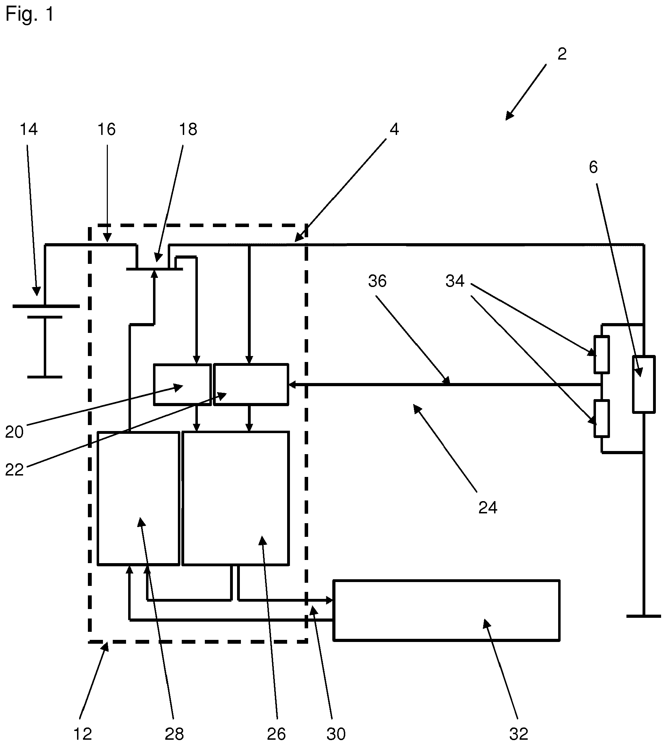

Das Grundprinzip der Überwachung wird nachfolgend anhand des in Fig. 1 dargestellten vereinfachten Kraftfahrzeug-Versorgungsnetz 2 erläutert, welches lediglich einen Laststrompfad 4 und dementsprechend eine Last 6 umfasst. Dieses Grundprinzip lässt sich jedoch problemlos auf mehrere Laststrompfade 4 und dementsprechend mehrere Lasten 6 übertragen und somit auch beim Kraftfahrzeug-Versorgungsnetz 2 gemäß Fig. 2 anwenden.

Zur Überwachung des Laststrompfades 4 und somit zur Realisierung des Sicherungssystems des Kraftfahrzeug-Versorgungsnetzes 2 weist der Leistungsverteiler 12, der in Fig. 1 genauso wie in Fig. 2 durch eine gestrichelte Umrandung markiert ist, mehrere Funktionseinheiten oder Funktionsbausteine auf, die im Ausführungsbeispiel auf einer gemeinsamen Leiterplatine untergebracht und von einem gemeinsamen Gehäuse umgeben sind.

Eine Funktionseinheit ist durch einen Halbleiterschalter 18 gegeben, der bei Erkennung eines drohenden Störfalls geöffnet oder gesperrt wird, um so die Last 6 von der Versorgung mit elektrischer Energie abzukoppeln, also um den elektrischen Verbraucher, der über den entsprechenden Lastrompfad 4 versorgt wird, abzuschalten. Dabei ist der Halbleiterschalter 18 in den entsprechenden Laststrompfad 4 integriert und dient zusätzlich zum An- und Ausschalten des entsprechenden elektrischen Verbrauchers gemäß Bedarf.

Als weitere Funktionseinheit umfasst der Leistungsverteiler 12 eine Strommesseinheit 20, mit deren Hilfe der über den Laststrompfad 4 fließende Strom durch Erfassung der Stromstärke überwacht wird. Die Strommesseinheit 20 ist hierzu unmittelbar an einen Strommessausgang am Halbleiterschalter 18 signaltechnisch angeschlossen oder aber die Stromesseinheit 20 ist vollständig in den Halbleiterschalter 18 integriert.

Ergänzend zur Strommesseinheit 20 umfasst der Leistungsverteiler 12 eine Spannungsmesseinheit 22, die in eine in Fig. 1 nur teilweise dargestellte Spannungsmessbrücke eingebunden ist. Diese basiert auf dem Prinzip einer Wheadston'schen Messbrücke und ist bereits in der auf die Anmelderin zurückgehenden DE 10 2012 019 996 A1 beschrieben, weswegen an dieser Stelle nochmals ausdrücklich auf diese Offenlegungsschrift Bezug genommen wird.

Hierbei dienen sowohl die Strommesseinheit 20 als auch die Spannungsmesseinheit 22 mitsamt der Spannungsmessbrücke 24 lediglich zur Erfassung einer Stromstärke und einer Spannung, wohingegen die Auswertung der erfassten Messdaten, insbesondere des zeitlichen Verlaufs der erfassten Stromstärke und des zeitlichen Verlaufs der erfassten Spannung, in einer Überwachungseinheit 26 erfolgt, die als weitere Funktionseinheit des Sicherungssystems Bestandteil des Leistungsverteiler 12 ist. In der Überwachungseinheit 26 erfolgt dann ein Vergleich der mittels der Strommesseinheit 20 erfassten Stromstärke mit mehreren in einem Speicher der Überwachungseinheit 26 hinterlegten Stromprofilen die einen charakteristischen zeitlichen Verlauf der Stromstärke vor und beim Auftreten eines Störfalls wiedergeben, wodurch bei einer messtechnischen Erfassung eines vergleichbaren zeitlichen Verlaufs der mittels der Strommesseinheit 20 erfassten Stromstärke auf einen drohenden Störfall geschlossen werden kann. Parallel erfolgt eine analoge Auswertung der Messdaten der Spannungsmesseinheit 22, wobei auch hierfür wiederum mehrere Spannungsprofile im Speicher der Überwachungseinheit 26 hinterlegt sind.

Dabei ist die Überwachungseinheit 26 derart ausgelegt, dass die Erkennung von drohenden Überstrom-Störfällen allein beim Auftreten eines charakteristischen zeitlichen Verlaufs der Stromstärke im Laststrompfad 4 erkannt wird, wohingegen die drohenden Lichtbogen-Störfälle erkannt werden, wenn sowohl ein charakteristischer zeitlicher Verlauf der Stromstärke als auch ein charakteristischer zeitlicher Verlauf der mittels der Spannungsmesseinheit 22 erfassten Spannung ermittelt wird. Auf diese Weise werden dann verschiedene Arten von drohenden Störfällen als drohende Störfälle erkannt, wobei unabhängig von der Art des drohenden Störfalls eine Reaktion der Überwachungseinheit 26 derart erfolgt, dass dieser die Öffnung oder Sperrung des Halbleiterschalters 18 initiiert, und hierfür ein Steuersignal an einen Verstärker 28 übermittelt.

Zusätzlich wird bei einem Auftreten eines drohenden Störfalls in der Überwachungseinheit 26 ein Störprotokoll generiert und über einen Signalausgang 30 am Leistungsverteiler 12 an einen externen Empfänger, im Ausführungsbeispiel ein Steuergerät 32 im Bordnetz des Kraftfahrzeuges, übermittelt. Im Steuergerät 32 wird das Störprotokoll dann in ein Fehlerprotokoll eingebunden und in einem Fehlerspeicher hinterlegt, welcher typischer Weise im Rahmen einer Wartung des Kraftfahrzeuges von einem Wartungstechniker ausgelesen wird. Hierdurch wird dann der Wartungstechniker auf das vorliegende Problem hingewiesen.

Im Falle des Kraftfahrzeug-Versorgungsnetzes 2 gemäß Fig. 2 wird der Wartungstechniker durch das Fehlerprotokoll im Fehlerspeicher nicht nur auf das vorliegen eines Problems aufmerksam gemacht, darüber hinaus enthält das Fehlerprotokoll auch die Information, in welchen Laststrompfad 4 des Kraftfahrzeug-Versorgungsnetzes 2 das entsprechende Problem vorliegt. Davon abgesehen erfolgt die Überwachung der einzelnen Laststrompfade 4 des Kraftfahrzeug-Versorgungsnetzes 2 gemäß Fig. 2 nach demselben Prinzip wie im Falle des Kraftfahrzeug-Versorgungsnetzes 2 gemäß Fig. 1, wobei für jeden Laststrompfad 4 ein eigener Halbleiterschalter 18, eine eigene Strommesseinheit 20 sowie eine eigene Spannungsmessbrücke 24 mit eingebundener Spannungsmesseinheit 22 vorgesehen und dementsprechend im Leistungsverteiler 12 realisiert sind.

Die Auswertung der zu den einzelnen Laststrompfaden 4 gehörigen Messdaten erfolgt hingegen in einer einzigen Überwachungseinheit 26, die dementsprechend an alle Strommesseinheiten 20 und alle Spannungsmesseinheiten 22 im Leistungsverteiler 12 angebunden ist. Beim Auftreten eines drohenden Störfalls in einem der Laststrompfade 4 steuert die eine Überwachungseinheit 26 den zum entsprechenden Laststrompfad 4 gehörigen Halbleiterschalter 18 an, wodurch der entsprechende Laststrompfad 4 von der Leistungsversorgung getrennt wird. Dabei erfolgt die Ansteuerung im Ausführungsbeispiel gemäß Fig. 2 direkt durch die Uberwachungseinheit 26, die nach Art eines Mikrokontrollers aufgebaut ist und für die Ansteuerung der Halbleiterschalter 18 im Leistungsverteiler 12 einen integrierten Signalverstärker aufweist. Auch die bedarfsweise Ansteuerung der Halbleiterschalter 18 im Leistungsverteiler 12, also das An- und Ausschalten der elektrischen Verbraucher, erfolgt im Kraftfahrzeug-Versorgungsnetz gemäß Fig. 2 durch die Überwachungseinheit 26, wobei die entsprechende Ansteuerung der Halbleiterschalter 18 auf der Basis von Steuersignalen erfolgt, die über das Steuergerät 32 an die Überwachungseinheit 26 übermittelt werden.

In Fig. 1 sind zwei im Bereich der Last 6 dargestellte Wiederstände 34 sowie eine Sensorleitung oder Signalleitung 36 mit abgebildet, die Teil der Spannungsmessbrücke 24 und in Fig. 2 nicht explizit dargestellt sind, jedoch für jeden Laststrompfad 4 im Kraftfahrzeug-Versorgungsnetz 2 realisiert sind. Die entsprechenden Wiederstände 34 sind dabei jeweils im lastseitigen Stecker 10 eines jeden Kabels 8 integriert und die Signalleitung 36 ist entweder durch eine zusätzliche Ader in einem jeden Kabel 8 oder durch eine Schirmung in einem jeden Kabel 8 gegeben.

### Bezugszeichenliste

- 2: Kraftfahrzeug-Versorgungsnetz
- 4: Laststrompfad
- 6: Last
- 8: Kabel
- 10: Stecker
- 12: Leistungsverteiler
- 14: Stromquelle
- 16: Zuleitungsstrompfad
- 18: Halbleiterschalter
- 20: Strommesseinheit
- 22: Spannungsmesseinheit
- 24: Spannungsmessbrücke
- 26: Überwachungseinheit
- 28: Verstärker
- 30: Signalausgang
- 32: Steuergerät
- 34: Widerstand
- 36: Signalleitung

## Patentansprüche

1. Kraftfahrzeug-Versorgungsnetz (2), insbesondere 48V-Bordnetz eines Kraftfahrzeuges, umfassend eine Stromquelle (14), einen Leistungsverteiler (12), der über einen Zuleitungsstrompfad (16) an die Stromquelle (14) angebunden ist, sowie zumindest eine Last (6), die über einen Laststrompfad (4) mit integriertem Halbleiterschalter (18) an den Leistungsverteiler (12) angebunden ist und über den Leistungsverteiler (12) mit der Stromquelle (14) verbunden ist,
wobei in den Leistungsverteiler (12) eine Strommesseinheit (20), eine Spannungsmesseinheit (22) sowie eine Überwachungseinheit (26) integriert sind und wobei die Überwachungseinheit (26) derart eingerichtet ist, dass diese einen drohenden Störfall anhand der Messdaten der Strommesseinheit (20) und/oder der Messdaten der Spannungsmesseinheit (22) erkennt und dass diese ein Abschalten der zumindest einen Last (6) mittels des Halbleiterschalters (18) initiiert, wobei sowohl drohende Überstrom-Störfälle als auch drohende Lichtbogen-Störfälle als drohender Störfall erkannt werden, wobei der Zuleitungsstrompfad (16) im Leistungsverteiler (12) sich in mehrere Laststrompfade (4) aufteilt und über jeden dieser Laststrompfade (4) eine Last (6) am Leistungsverteiler (12) angebunden ist, wobei in jedem Laststrompfad (4) ein Halbleiterschalter (18) integriert ist und wobei die Überwachungseinheit (26) eingerichtet ist, um alle Laststrompfade (4) unabhängig voneinander zu überwachen, so dass bei einem Störfall in einem der Laststrompfade (4) lediglich die daran angebundene Last (6) abgeschaltet wird.

2. Kraftfahrzeug-Versorgungsnetz (2) nach Anspruch 1,
wobei zumindest der in den Laststrompfad mit der zumindest einen Last integrierte Halbleiterschalter als Leistungstransistor und insbesondere als MOSFET ausgebildet ist.

3. Kraftfahrzeug-Versorgungsnetz (2) nach Anspruch 1 und 2,
wobei auf einer gemeinsamen Leiterplatine für jede der Lasten (6) ein jeweiliger Halbleiterschalter (18), eine jeweilige Strommesseinheit (20), eine jeweilige Spannungsmesseinheit (22) sowie eine für alle Lasten (6) gemeinsame Überwachungseinheit (26) angeordnet sind, die für jede Last (6) zur Erfassung
- eines Überstroms,
- eines Kurzschlusses des Laststrompfades (4) gegen Masse,
- eines parallelen Lichtbogens im Laststrompfad (4),
- eines seriellen Lichtbogens im Laststrompfad (4) sowie zur Erfassung
- eines seriellen Lichtbogens in einem Massepfad zwischen der jeweiligen Last (4) und einem Massepotenzial
ausgebildet ist.

4. Kraftfahrzeug-Versorgungsnetz (2) nach einem der Ansprüche 1 bis 3, wobei die Strommesseinheit (20) für die Überwachung des Strompfades (4) mit der zumindest einen Last (6) in den Halbleiterschalter (18) des entsprechenden Laststrompfades (4) integriert ist.

5. Kraftfahrzeug-Versorgungsnetz (2) nach einem der Ansprüche 1 bis 4, wobei die Überwachungseinheit (26) eingerichtet ist, um einen drohenden Störfall und die Art des drohenden Störfalls zu erkennen.

6. Kraftfahrzeug-Versorgungsnetz (2) nach einem der Ansprüche 1 bis 5,
wobei die Überwachungseinheit (26) eingerichtet ist, um einen drohenden Störfall und die Art des drohenden Störfalls zu erkennen, indem die Messdaten der Strommesseinheit (20) und/oder die Messdaten der Spannungsmesseinheit (22) mit hinterlegten Strom-und/oder Spannungsprofilen abgeglichen werden.

7. Kraftfahrzeug-Versorgungsnetz (2) nach Anspruch 5 oder Anspruch 6, wobei die Überwachungseinheit (26) derart eingerichtet ist, dass ein Störfallprotokoll generiert und über einen Signalausgang (30) am Leistungsverteiler (12) an einen Empfänger übermittelt wird, wenn ein drohender Störfall erkannt wurde.

8. Kraftfahrzeug-Versorgungsnetz (2) nach einem der Ansprüche 1 bis 7, wobei die Überwachungseinheit (26) zur Erkennung von drohenden Lichtbogen-Störfällen in einem Laststrompfad (4) die mittels der Spannungsmesseinheit (22) erfasste Potentialdifferenz in einer Messbrücke (24) mit einem Brückenkopf im Bereich der Last (6) dieses Laststrompfades (4) und mit einem Brückenkopf im Bereich des Halbleiterschalters (18) dieses Laststrompfades (4) überwacht.

9. Kraftfahrzeug-Versorgungsnetz (2) nach Anspruch 8,
wobei die Ausgestaltung der Messbrücke (24) auf dem Prinzip der Wheatstone'schen Messbrücke basiert.

10. Kraftfahrzeug-Versorgungsnetz (2) nach Anspruch 8 oder Anspruch 9, wobei eine Sensorleitung (36) vom Brückenkopf im Bereich der Last (6) ausgehend in den Leistungsverteiler (12) geführt ist, die zumindest in einem Abschnitt durch eine Ader oder eine Schirmung eines Leistungsübertragungs-Kabels (8) ausgebildet ist, durch welches die Last (6) mit dem Leistungsverteiler (12) verbunden ist.

11. Kraftfahrzeug-Versorgungsnetz (2) nach einem der Ansprüche 8 bis 10, wobei der Brückenkopf im Bereich der Last (6) in einen Steckverbinder (10) eines Leistungsübertragungs-Kabels (8) integriert ist, durch welches die Last (6) mit dem Leistungsverteiler (12) verbunden ist.

12. Kraftfahrzeug-Versorgungsnetz (2) nach Anspruch 1,
wobei zumindest der in den Laststrompfad mit der zumindest einen Last integrierte Halbleiterschalter als Leistungstransistor ausgebildet ist, wobei auf einer gemeinsamen Leiterplatine für jede der Lasten (6) ein jeweiliger Halbleiterschalter (18), eine jeweilige Strommesseinheit (20), eine jeweilige Spannungsmesseinheit (22) sowie eine für alle Lasten (6) gemeinsame Überwachungseinheit (26) angeordnet sind, die für jede Last (6) zur Erfassung
- eines Überstroms,
- eines Kurzschlusses des Laststrompfades (4) gegen Masse,
- eines parallelen Lichtbogens im Laststrompfad (4),
- eines seriellen Lichtbogens im Laststrompfad (4) sowie zur Erfassung
- eines seriellen Lichtbogens in einem Massepfad zwischen der jeweiligen Last (4) und einem Massepotenzial
ausgebildet ist,
wobei die Überwachungseinheit (26) zur Erkennung von drohenden Lichtbogen-Störfällen in einem Laststrompfad (4) die mittels der Spannungsmesseinheit (22) erfasste Potentialdifferenz in einer Messbrücke (24) mit einem Brückenkopf im Bereich der Last (6) dieses Laststrompfades (4) und mit einem Brückenkopf im Bereich des Halbleiterschalters (18) dieses Laststrompfades (4) überwacht,
wobei der Brückenkopf im Bereich der Last (6) in einen Steckverbinder (10) eines Leistungsübertragungs-Kabels (8) integriert ist, durch welches die Last (6) mit dem Leistungsverteiler (12) verbunden ist.

13. Leistungsverteiler (12) für ein Kraftfahrzeug-Versorgungsnetz (2) nach einem der vorherigen Ansprüche,
in dem eine Strommesseinheit (20), eine Spannungsmesseinheit (22) sowie eine Überwachungseinheit (26) integriert sind, wobei der Leistungsverteiler (12) derart eingerichtet ist, dass er eingangsseitig über einen Zuleitungsstrompfad (10) mit der Stromquelle (14) verbindbar ist und ausgangsseitig mit zumindest einer Last (6) verbindbar ist, sodass eine Stromquelle (14) über den Leistungsverteiler (12) mit zumindest einer Last (6) verbindbar ist, und wobei die Überwachungseinheit (26) derart eingerichtet ist, dass diese einen drohenden Störfall anhand der Messdaten der Strommesseinheit (20) und/oder der Messdaten der Spannungsmesseinheit (22) erkennt und dass diese ein Abschalten der zumindest einen Last (6) mittels des Halbleiterschalters (18) initiiert, wobei sowohl drohende Überstrom-Störfälle als auch drohende Lichtbogen-Störfälle als drohender Störfall erkannt werden, wobei der Leistungsverteiler (12) derart ausgebildet ist, dass der Zuleitungsstrompfad (16) im Leistungsverteiler (12) sich in mehrere Laststrompfade (4) aufteilt und über jeden dieser Laststrompfade (4) eine Last (6) am Leistungsverteiler (12) angeschlossen werden kann, wobei in jedem Laststrompfad (4) ein Halbleiterschalter (18) integriert ist und wobei die Überwachungseinheit (26) eingerichtet ist, um alle Laststrompfade (4) unabhängig voneinander zu überwachen, so dass bei einem Störfall in einem der Laststrompfade (4) lediglich die daran angebundene Last (6) abgeschaltet wird.

## Claims

1. A motor vehicle supply network (2), in particular 48V on-board network of a motor vehicle, comprising a power source (14), a power distributor (12), which is connected to the power source (14) via a supply current path (16), and at least one load (6) which is connected to the power distributor (12) via a load current path (4) with an integrated semiconductor switch (18) and is connected to the power source (14) via the power distributor (12),
wherein a current measurement unit (20), a voltage measurement unit (22) and a monitoring unit (26) is integrated into the power distributor (12), and wherein the monitoring unit (26) is arranged in such a way as to detect an impending fault on the basis of the measurement data of the current measurement unit (20) and/or the measurement data of the voltage measurement unit (22) and that it initiates a disconnection of the at least one load (6) by means of the semiconductor switch (18), wherein both imminent overcurrent faults and imminent arc faults are detected as an imminent fault,
wherein the supply current path (16) in the power distributor (12) divides into a plurality of load current paths (4) and a load (6) is connected to the power distributor (12) via each of these load current paths (4), wherein a semiconductor switch (18) is integrated in each load current path (4), and wherein the monitoring unit (26) is arranged to monitor all the load current paths (4) independently of one another, so that in the event of a fault in one of the load current paths (4) only the load (6) connected thereto is switched off.

2. The motor vehicle supply network (2) according to claim 1,
wherein at least the semiconductor switch integrated in the load current path with the at least one load is configured as a power transistor and in particular as a MOSFET.

3. The motor vehicle supply network (2) according to claim 1 and 2,
wherein for each of the loads (6) a respective semiconductor switch (18), a respective current measurement unit (20), a respective voltage measurement unit (22) and a monitoring unit (26) which is common to all the loads (6) are arranged on a common printed circuit board, which monitoring unit (26) is configured for each load (6) for detecting
- an overcurrent,
- a short circuit of the load current path (4) to ground,
- a parallel arc in the load current path (4),
- a serial arc in the load current path (4) as well as for the detection of
- a serial arc in a ground path between the respective load (4) and a ground potential.

4. The motor vehicle supply network (2) according to any one of claims 1 to 3,
wherein the current measurement unit (20) for monitoring the current path (4) with the at least one load (6) is integrated in the semiconductor switch (18) of the corresponding load current path (4).

5. The motor vehicle supply network (2) according to any one of claims 1 to 4,
wherein the monitoring unit (26) is arranged to detect an impending fault and the type of impending fault.

6. The motor vehicle supply network (2) according to any one of claims 1 to 5,
wherein the monitoring unit (26) is arranged to detect an impending fault and the type of impending fault by matching the measurement data of the current measurement unit (20) and/or the measurement data of the voltage measurement unit (22) with stored current and/or voltage profiles.

7. The motor vehicle supply network (2) according to claim 5 or claim 6,
wherein the monitoring unit (26) is arranged in such a way that a fault log is generated and transmitted to a receiver via a signal output (30) at the power distributor (12) when an imminent fault has been detected.

8. The motor vehicle supply network (2) according to any one of claims 1 to 7,
wherein the monitoring unit (26) for detecting impending arcing faults in a load current path (4) monitors the potential difference detected by means of the voltage measurement unit (22) in a measuring bridge (24) with a bridge head in the region of the load (6) of this load current path (4) and with a bridge head in the region of the semiconductor switch (18) of this load current path (4).

9. The motor vehicle supply network (2) according to claim 8,
wherein the design of the measuring bridge (24) is based on the principle of Wheatstone's measuring bridge.

10. The motor vehicle supply network (2) according to claim 8 or claim 9,
wherein a sensor line (36) is led from the bridge head in the region of the load (6) into the power distributor (12), which is formed at least in a section by a core or a shield of a power transmission cable (8) through which the load (6) is connected to the power distributor (12).

11. The motor vehicle supply network (2) according to any one of claims 8 to 10,
wherein the bridge head is integrated in the region of the load (6) into a plug connector (10) of a power transmission cable (8), through which the load (6) is connected to the power distributor (12).

12. The motor vehicle supply network (2) according to claim 1,
wherein at least the semiconductor switch integrated in the load current path with the at least one load is configured as a power transistor,
wherein for each of the loads (6) a respective semiconductor switch (18), a respective current measurement unit (20), a respective voltage measurement unit (22) and a monitoring unit (26) which is common to all the loads (6) are arranged on a common printed circuit board, which monitoring unit (26) is configured, for each load (6), for detecting
- an overcurrent
- a short circuit of the load current path (4) to ground,
- a parallel arc in the load current path (4),
- a serial arc in the load current path (4) as well as for the detection of
- of a serial arc in a ground path between the respective load (4) and a ground potential,
wherein the monitoring unit (26) monitoring the potential difference is detected by means of the voltage measurement unit (22) in a measuring bridge (24) with a bridge head in the region of the load (6) of this load current path (4) and with a bridge head in the region of the semiconductor switch (18) of this load current path (4) in order to detect impending arcing faults in a load current path (4),
wherein the bridge head is integrated in the region of the load (6) into a plug connector (10) of a power transmission cable (8) through which the load (6) is connected to the power distributor (12).

13. A power distributor (12) for a motor vehicle supply network (2) according to any one of the preceding claims,
in which a current measurement unit (20), a voltage measurement unit (22) and a monitoring unit (26) are integrated, wherein the power distributor (12) is arranged in such a way that it can be connected on the input side to the power source (14) via a supply current path (10) and can be connected on the output side to at least one load (6), so that a power source (14) can be connected to at least one load (6) via the power distributor (12), and
wherein the monitoring unit (26) is arranged in such a way that it detects an impending fault on the basis of the measurement data of the current measurement unit (20) and/or the measurement data of the voltage measurement unit (22) and that it initiates a disconnection of the at least one load (6) by means of the semiconductor switch (18), wherein both imminent overcurrent faults and imminent arc faults are detected as an imminent fault, wherein the power distributor (12) is configured in such a way that the supply current path (16) in the power distributor (12) divides into several load current paths (4) and a load (6) can be connected to the power distributor (12) via each of these load current paths (4), wherein a semiconductor switch (18) is integrated in each load current path (4) and wherein the monitoring unit (26) is arranged to monitor all load current paths (4) independently of one another, so that in the event of a fault in one of the load current paths (4) only the load (6) connected thereto is switched off.

## Revendications

1. Réseau d'alimentation (2) de véhicule automobile, en particulier réseau de bord 48V d'un véhicule automobile, comprenant une source de courant (14), un distributeur de puissance (12) qui est relié à la source de courant (14) via un trajet de courant d'alimentation (16), ainsi qu'au moins une charge (6) qui est reliée au distributeur de puissance (12) via un trajet de courant de charge (4) à commutateur à semi-conducteur (18) intégré et est reliée à la source de courant (14) via le distributeur de puissance (12),
dans lequel une unité de mesure de courant (20), une unité de mesure de tension (22) ainsi qu'une unité de surveillance (26) sont intégrées dans le distributeur de puissance (12) et l'unité de surveillance (26) étant disposée de telle façon qu'elle détecte une défaillance imminente à l'aide des données de mesure de l'unité de mesure de courant (20) et/ou des données de mesure de l'unité de mesure de tension (22) et de telle façon qu'elle déclenche une mise hors circuit de ladite au moins une charge (6) au moyen du commutateur à semi-conducteur (18), aussi bien des défaillances de surintensité imminentes que des défaillances d'arc électrique imminentes étant détectées en tant que défaillance imminente,
dans lequel le trajet de courant d'alimentation (16) se divise dans le distributeur de puissance (12) en plusieurs trajets de courant de charge (4) et une charge (6) est reliée via chacun de ces trajets de courant de charge (4) au distributeur de puissance (12), dans lequel un commutateur à semi-conducteur (18) est intégré dans chaque trajet de courant de charge (4), et dans lequel l'unité de surveillance (26) est disposée pour surveiller tous les trajets de courant de charge (4) indépendamment les uns des autres, de sorte qu'en cas d'une défaillance dans l'un des trajet de courant de charge (4) seulement la charge (6) qui y est reliée est mise hors circuit.

2. Réseau d'alimentation (2) de véhicule automobile selon la revendication 1,
dans lequel au moins le commutateur à semi-conducteur intégré dans le trajet de courant de charge (4) avec ladite au moins une charge est conçu sous forme de transistor de puissance et en particulier sous forme de MOSFET.

3. Réseau d'alimentation (2) de véhicule automobile selon la revendication 1 ou 2,
dans lequel sur une carte à circuit imprimé commune sont disposés pour chacune des charges (6) un commutateur à semi-conducteur (18) respectif, une unité de mesure de courant (20) respective, une unité de mesure de tension (22) respective ainsi qu'une unité de surveillance (26) commune pour toutes les charges (6), qui pour chaque charge (6) est conçue pour la détection
- d'une surintensité,
- d'un court-circuit du trajet de courant de charge (4) à la masse,
- d'un arc électrique en parallèle dans le trajet de courant de charge (4),
- d'un arc électrique en série dans le trajet de courant de charge (4) ainsi que pour la détection
- d'un arc électrique en série dans un trajet à la masse entre la charge (4) respective et un potentiel de masse.

4. Réseau d'alimentation (2) de véhicule automobile selon l'une quelconque des revendications 1 à 3,
dans lequel pour la surveillance du trajet de courant (4) avec ladite au moins une charge (6) l'unité de mesure de courant (20) est intégrée dans le commutateur à semi-conducteur (18) du trajet de courant de charge (4) correspondant.

5. Réseau d'alimentation (2) de véhicule automobile selon l'une quelconque des revendications 1 à 4,
dans lequel l'unité de surveillance (26) est disposée pour détecter une défaillance imminente et la nature de la défaillance imminente.

6. Réseau d'alimentation (2) de véhicule automobile selon l'une quelconque des revendications 1 à 5,
dans lequel l'unité de surveillance (26) est disposée pour détecter une défaillance imminente et la nature de la défaillance imminente en comparant les données de mesure de l'unité de mesure de courant (20) et/ou les données de mesure de l'unité de mesure de tension (22) à des profils de courant et/ou de tension enregistrés.

7. Réseau d'alimentation (2) de véhicule automobile selon la revendication 5 ou la revendication 6,
dans lequel l'unité de surveillance (26) est disposée de telle façon que lorsqu'une défaillance imminente a été détectée un protocole de défaillance est engendré et transmis à un récepteur via une sortie de signal (30) sur le distributeur de puissance (12).

8. Réseau d'alimentation (2) de véhicule automobile selon l'une quelconque des revendications 1 à 7,
dans lequel dans la détection de défaillances d'arc électrique imminentes dans un trajet de courant de charge (4) l'unité de surveillance (26) surveille la différence de potentiel déterminée au moyen de l'unité de mesure de tension (22) dans un pont de mesure (24) comportant une tête de pont dans la zone de la charge (6) de ce trajet de courant de charge (4) et comportant une tête de pont dans la zone du commutateur à semi-conducteur (18) de ce trajet de courant de charge (4).

9. Réseau d'alimentation (2) de véhicule automobile selon la revendication 8,
dans lequel la configuration des ponts de mesure (24) est basée sur le principe des ponts de mesure de Wheatstone.

10. Réseau d'alimentation (2) de véhicule automobile selon la revendication 8 ou la revendication 9,
dans lequel une ligne de capteur (36) est conduite dans le distributeur de puissance (12) en sortant de la tête de pont dans la zone de la charge (6), qui au moins dans un segment est constituée d'un conducteur ou d'un blindage d'un câble (8) de transmission de puissance, par lequel la charge (6) est reliée au distributeur de puissance (12).

11. Réseau d'alimentation (2) de véhicule automobile selon l'une quelconque des revendications 8 à 10,
dans lequel la tête de pont dans la zone de la charge (6) est intégrée dans un connecteur à fiche (10) d'un câble (8) de transmission de puissance, par lequel la charge (6) est reliée au distributeur de puissance (12).

12. Réseau d'alimentation (2) de véhicule automobile selon la revendication 1,
dans lequel au moins le commutateur à semi-conducteur intégré dans le trajet de courant de charge avec ladite au moins une charge est conçu sous forme de transistor de puissance,
dans lequel sur une carte à circuit imprimé commune sont disposés pour chacune des charges (6) un commutateur à semi-conducteur (18) respectif, une unité de mesure de courant (20) respective, une unité de mesure de tension (22) respective ainsi qu'une unité de surveillance (26) commune pour toutes les charges (6), qui pour chaque charge (6) est conçue pour la détection
- d'une surintensité,
- d'un court-circuit du trajet de courant de charge (4) à la masse,
- d'un arc électrique en parallèle dans le trajet de courant de charge (4),
- d'un arc électrique en série dans le trajet de courant de charge (4) ainsi que pour la détection
- d'un arc électrique en série dans un trajet à la masse entre la charge (4) respective et un potentiel de masse,
dans lequel, dans la détection de défaillances d'arc électrique imminentes dans un trajet de courant de charge (4), l'unité de surveillance (26) surveille la différence de potentiel déterminée au moyen de l'unité de mesure de tension (22) dans un pont de mesure (24) comportant une tête de pont dans la zone de la charge (6) de ce trajet de courant de charge (4) et comportant une tête de pont dans la zone du commutateur à semi-conducteur (18) de ce trajet de courant de charge (4),
dans lequel la tête de pont dans la zone de la charge (6) est intégrée dans un connecteur à fiche (10) d'un câble (8) de transmission de puissance, par lequel la charge (6) est reliée au distributeur de puissance (12).

13. Distributeur de puissance (12) pour un réseau d'alimentation (2) de véhicule automobile selon l'une quelconque des revendications précédentes,
dans lequel sont intégrées une unité de mesure de courant (20), une unité de mesure de tension (22) ainsi qu'une unité de surveillance (26), dans lequel le distributeur de puissance (12) est disposé de telle façon qu'il peut être connecté, du côté de l'entrée, à la source de courant (14) via un trajet de courant d'alimentation (10) et, du côté de la sortie, à au moins une charge (6), de sorte qu'une source de courant (14) peut être connectée à au moins une charge (6) via le distributeur de puissance (12), et
dans lequel l'unité de surveillance (26) est disposée de telle façon qu'elle détecte une défaillance imminente à l'aide des données de mesure de l'unité de mesure de courant (20) et/ou des données de mesure de l'unité de mesure de tension (22) et de telle façon qu'elle déclenche une mise hors circuit de ladite au moins une charge (6) au moyen du commutateur à semi-conducteur (18), aussi bien des défaillances de surintensité imminentes que des défaillances d'arc électrique imminentes étant détectées en tant que défaillance imminente, dans lequel le distributeur de puissance (12) est conçu de telle façon que le trajet de courant d'alimentation (16) se divise dans le distributeur de puissance (12) en plusieurs trajets de courant de charge (4) et une charge (6) peut être reliée via chacun de ces trajets de courant de charge (4) au distributeur de puissance (12), dans lequel un commutateur à semi-conducteur (18) est intégré dans chaque trajet de courant de charge (4), et dans lequel l'unité de surveillance (26) est disposée pour surveiller tous les trajets de courant de charge (4) indépendamment les uns des autres, de sorte qu'en cas d'une défaillance dans l'un des trajets de courant de charge (4) seulement la charge (6) qui y est reliée est mise hors circuit.
